# EUROPÄISCHE PATENTSCHRIFT

(11) **EP 1 150 376 B1**
(45) Veröffentlichungstag und Bekanntmachung des Hinweises auf die Patenterteilung: **31.03.2004**
(21) Anmeldenummer: 01109809.2
(22) Anmeldetag: 21.04.2001
(51) Int. Cl.: H01P 1/213

(54) **Einrichtung zur Reduktion der Antennenanzahl an einem Kampffahrzeug**
Device for reduction of the number of antennas on a combat vehicle
Dispositif pour réduire le nombre d'antennes sur un char de combat

(30) Priorität: 27.04.2000 DE 20007619 U
(43) Veröffentlichungstag der Anmeldung: 31.10.2001
(73) Patentinhaber: Krauss-Maffei Wegmann GmbH & Co. KG, 34127 Kassel (DE)
(72) Erfinder: Scheibel, Axel, Dr., 34266 Niestetal (DE)
(74) Vertreter: Feder, Wolf-Dietrich, Dr. Dipl.-Phys.

(56) Entgegenhaltungen:
- GB-A- 2 115 613
- US-A- 2 788 495
- US-A- 5 147 493
- US-A- 6 052 039
- MALEVICH I Y: "A LOW-LOSS SPLITTER" TELECOMMUNICATIONS AND RADIO ENGINEERING, BEGELL HOUSE, INC., NEW YORK, NY, US, Bd. 48, Nr. 4, 1. April 1993 (1993-04-01), Seiten 30-31, XP000476147 ISSN: 0040-2508

## Beschreibung

Die Erfindung betrifft eine elektrische Kombinator-Teiler-Einheit mit den Merkmalen aus dem Oberbegriff des Patentanspruchs 1.

Eine derartige Einheit ist beispielsweise aus US-A-5147493 bekannt Sie dient dort zur Übertragung von elektrischer Energie von einer Hochfrequenz-Leistungsquelle auf eine plasmaerzeugende Einrichtung, indem von den beiden Enden der Sekundärwicklung des Transformators die elektrische HF-Leistung mit einer Phasenverschiebung von 180° den beiden Elektroden der plasmaerzeugenden Einrichtung zugeführt wird, die beispielsweise zum Ätzen von Oxyd-Schichten bei der Halbleiterherstellung verwendet werden soll.

Es ist weiterhin aus US-A-6052039 ein Schaltkreis aus konzentrierten Schaltelementen zur Anwendung in einem monolithischen integrierten Mikrowellen-Schaltkreis bekannt, wobei Schaltkreise zur Anpassung eines symmetrischen Systems an ein unsymmetrisches System beschrieben werden, die einem Transformator bei niedrigen Frequenzen entsprechen, mit einem Master-Tor an der Eingangsseite und mehreren Paaren von Slave-Toren an der Ausgangsseite, wobei jeweils die Ausgangssignale an den beiden Slave-Toren eines Paares eine Phasendifferenz von 180° aufweisen.

In der jüngsten Zeit besteht auch im militärischen Bereich ein stetig steigender Bedarf an Kommunikation. Dieser Bedarf ergibt sich sowohl auf dem Gebiet der klassischen stationären Kommunikationseinrichtungen als auch auf dem Sektor der mobilen Kommunikation. Der aufgezeigten Entwicklung folgend sind moderne Kampffahrzeuge mit einer Vielzahl von Kommunikationsendgeräten ausgestattet. Diese dienen sowohl zur Übertragung von allgemeinen Informationen als auch zur individuellen Kommunikation zwischen ausgewählten Systemkomponenten (Datenendgeräte oder Gesprächsteilnehmer). Infolge der statistischen Unabhängigkeit der Daten, die dabei übertragen werden, ist kein festes Schema für den Datenverkehr zwischen den verschiedenen Kommunikationssystemen vorhanden. Daher ist prinzipiell ein Parallelbetrieb aller Funkgeräte - gegebenenfalls auch im gleichen Frequenzband - zu gewährleisten.

Heutige Kampffahrzeuge sind im allgemeinen mit zwei getrennten Antennen versehen, die am Heck des Kampffahrzeugs angeordnet sind. Aus physikalischen Gründen ist es jedoch günstiger, eine Antenne systemtechnisch optimal am Fahrzeug anzuordnen, was aber beim Vorhandensein von mehreren Antennen nicht möglich ist.

Der Erfindung liegt die Aufgabe zugrunde eine Einrichtung zu schaffen, mittels der es möglich ist, mit einfachen Mitteln die Anzahl der Antennen am Kampffahrzeug zu reduzieren und insbesondere anstelle von zwei Antennen nur eine Antenne zu installieren, die dann systemtechnisch optimal angeordnet werden kann.

Dabei waren folgende technische Probleme zu lösen:
a) Prioritätenfreie parallele Mehrfachnutzung einer Antenne; mehrere Funkgeräte können zeitgleich auf eine Antenne zugreifen. Eine geringe Reduktion der Reichweite ist dabei zulässig.
b) Die Antennenweiche muß - gemäß Funkgerätespezifikation - ein Hochfrequenzsignal im Frequenzbereich von 30 - 110 MHz transferieren.
c) Hochfrequenzleistung;
   Die Antennenweiche muß - gemäß Funkgerätespezifikation - eine Hochfrequenzleistung von 50 Watt je adaptierten Funkgerät bidirektional transferieren.
d) HF-Entkopplung der parallelen Ports;
   Bei der Kopplung mehrerer Funkgeräte an eine Antenne ist unbedingt die Entkopplungsforderung des Herstellers zu gewährleisten. Eine Unterschreitung der Entkopplungsforderung würde direkt zu einer Zerstörung der Empfängereingangsstufen führen.
e) DC-Kopplung (Antenne/Funkgerät);
   Sicherstellung der Übertragung einer 50 V-Gleichspannung vom Funkgerät zum Antennenfuß. Diese Spannung ist als Vorspannung für ein Diodennetzwerk zur Gewährleistung des Blitzschutzes unumgänglich.
f) DC-Entkopplung (Funkgerät 1 / Funkgerät 2);
   Entkopplung der 50 V-Gleichspannung der einzelnen Funkgeräte zur Unterdrückung eines möglichen DC-Ausgleichsstromes über die Antenneneingänge.

Die Lösung der obengenannten Aufgabe erfolgt erfindungsgemäß mit den Merkmalen aus dem kennzeichnenden Teil des Patentanspruchs 1. Eine vorteilhafte Weiterbildung der erfindungsgemäßen Einrichtung ist in dem abhängigen Anspruch beschrieben.

Gemäß einem Grundgedanken der Erfindung hat sich herausgestellt, daß es möglich ist, zwei Kommunikationsendgeräte über eine Kombinator-Teiler-Einheit an eine gemeinsame Antenne anzuschließen, wobei zur Lösung der oben erläuterten technischen Probleme die Kombinator-Teiler-Einheit eine passive Antennenweiche aufweist, die derart modifiziert ist, daß die oben angegebenen Forderungen erfüllt werden.

Wie weiter unten anhand eines Ausführungsbeispiels ausführlicher erläutert, ist es mittels der erfindungsgemäßen Kombinator-Teiler-Einheit ohne weiteres möglich, unter Einhaltung der angegebenen Forderungen jeweils zwei Kommunikationsendgeräte an eine gemeinsame Antenne anzuschließen.

Im folgenden werden ein Ausführungsbeispiel der erfindungsgemäßen Einrichtung sowie die an ihm gemessenen Eigenschaften der Schaltung anhand der beigefügten Zeichnungen erläutert.

In den Zeichnungen zeigen:
Fig. 1 ein Schaltbild der erfindungsgemäßen Kombinator-Teiler-Einheit;
Fig. 2 in einem Signalleistungs-Verhältnis/Frequenz-Diagramm die von Tor 1 der Schaltung nach Fig. 1 reflektierte Signalleistung;
Fig. 3 in einem Diagramm analog Fig. 2 die von Tor 2 der Schaltung nach Fig. 1 reflektierte Signalleistung;
Fig. 4 in einem Diagramm analog Fig. 2 die von Tor 3 der Schaltung nach Fig. 1 reflektierte Signalleistung;
Fig. 5 in einem Diagramm analog Fig. 2 die zwischen Tor 1 und Tor 2 der Schaltung nach Fig. 1 übertragene Signalleistung;
Fig. 6 in einem Diagramm analog Fig. 2 die zwischen Tor 1 und 3 der Schaltung nach Fig. 1 übertragene Signalleistung;
Fig. 7 in einem Diagramm analog Fig. 2 die zwischen den Toren 2 und 3 der Schaltung nach Fig. 1 übertragene Signalleistung.

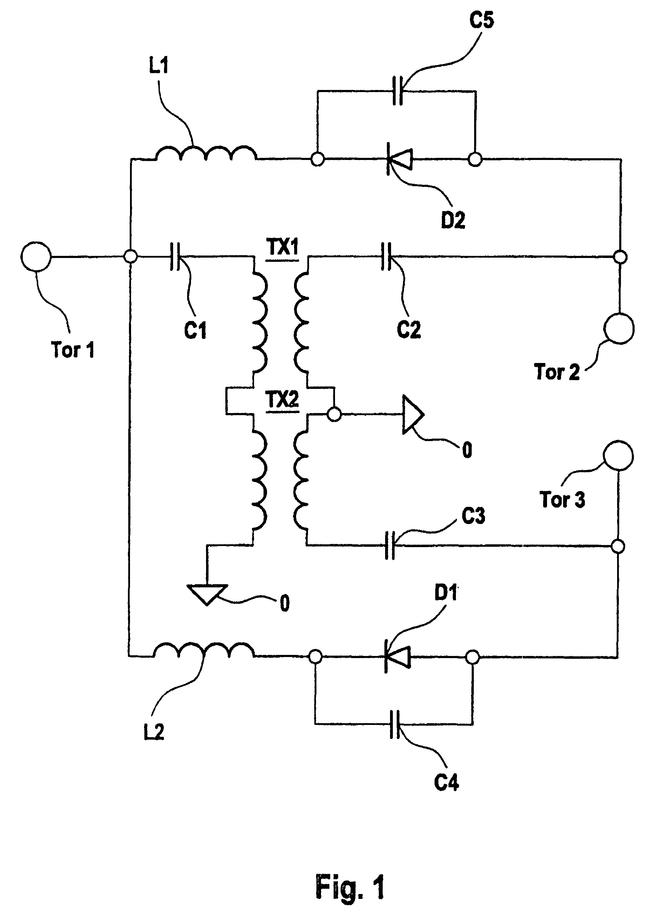

In Fig. 1 ist eine Kombinator-Teiler-Einheit dargestellt, mit der zwei nicht dargestellte Kommunikationsendgeräte eines Kampffahrzeugs an eine ebenfalls nicht dargestellte gemeinsame Antenne angeschlossen werden. Die Kombinator-Teiler-Einheit besitzt ein als Master-Tor anzusehendes "Tor 1" zum Anschluß der Antenne und zwei Slave-Tore "Tor 2" und "Tor 3" zum Anschluß der beiden Kommunikationsendgeräte. Tor 1 ist mit den Toren 2 und 3 über eine Transformatorschaltung TX1 gekoppelt. Dies erfolgt in der Weise, daß die Primärwicklung der Transformatorschaltung TX1 an einem Ende mit dem Tor 1 und am anderen Ende mit 0-Potential verbunden ist, während die Sekundärwicklung an beiden Enden jeweils mit einem der Tore 2 und 3 und am Mittelabgriff TX2 mit 0-Potential verbunden ist. Die gleichstrommäßige Entkoppelung der Tore 1, 2 und 3 von der Transformatorschaltung TX1 erfolgt durch Kondensatoren C1, C2 und C3.

Weiterhin ist Tor 1 über einen Bypasszweig mit einer Drossel L1 und einer in Richtung auf Tor 1 gepolten Diode D2, der ein Kondensator C5 parallelgeschaltet ist, mit Tor 2 verbunden. Über einen weiteren Bypasszweig mit einer Drossel L2 und einer in Richtung auf Tor 1 gepolten Diode D1, der ein Kondensator C4 parallelgeschaltet ist, ist Tor 1 mit Tor 3 verbunden.

Die in Fig. 1 dargestellten Schaltelemente lassen sich leicht so dimensionieren, daß die dargestellte Kombinator-Teiler-Einheit ausschließlich Frequenzen im Bereich von 2 bis 220 MHz überträgt. Darüber hinaus werden Gleichspannungssignale, welche an einem der Tore anliegen, als Folge der Induktivitäten gegen das Massepotential kurzgeschlossen.

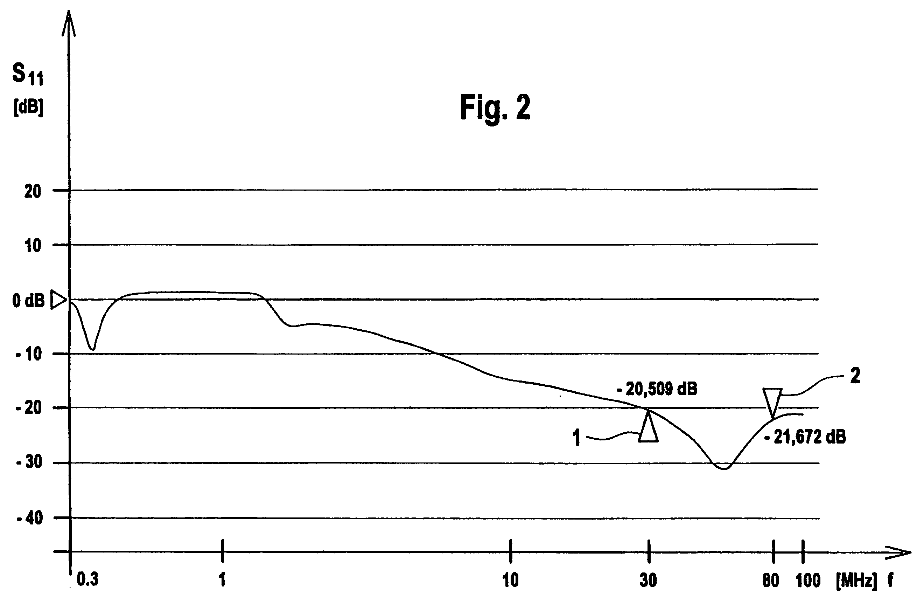

Die Dimensionierung der einzelnen Bauteile der Schaltung nach Fig. 1 im Hinblick auf eine optimale Funktion der vollständigen Baugruppe kann unter Anwendung eines Schaltungssimulationsprogramms ermittelt werden. Im folgenden werden die Eigenschaften eines derartigen Ausführungsbeispiels anhand durchgeführter Messungen erläutert. In den Fig. 2 bis 7 ist jeweils ein Signalleistungs-Verhältnis in dB über einen jeweils von 0,3 bis 100 MHz reichenden Bereich der Frequenz f dargestellt, wobei die Frequenz im logarithmischen Maßstab aufgetragen ist.

Dabei sind in allen Figuren durch entsprechende Pfeilmarkierungen zwei besonders wichtige Frequenzpunkte besonders herausgehoben, nämlich einmal durch "Pfeil 1" die Frequenz von 30 MHz und einmal durch "Pfeil 2" die Frequenz von 80 MHz.

In Fig. 2 bedeutet S₁₁ die von Tor 1 der Schaltung nach Fig. 1 reflektierte Signalleistung in Abhängigkeit von der Frequenz. Aus den Werten -20,509 dB bei 30 MHz und -21,672 dB bei 80 MHz kann ermittelt werden, wie gering diese Reflektion ist.

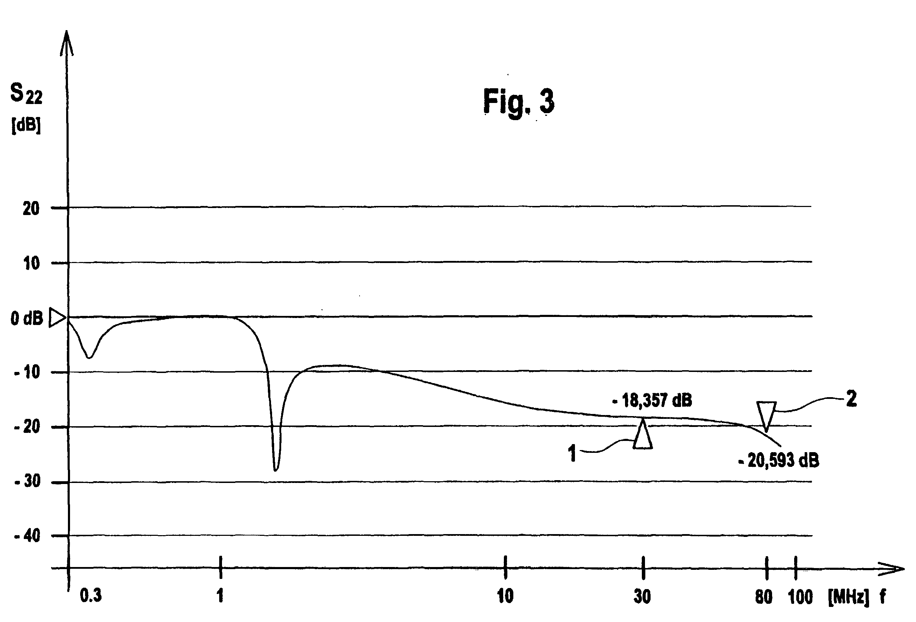

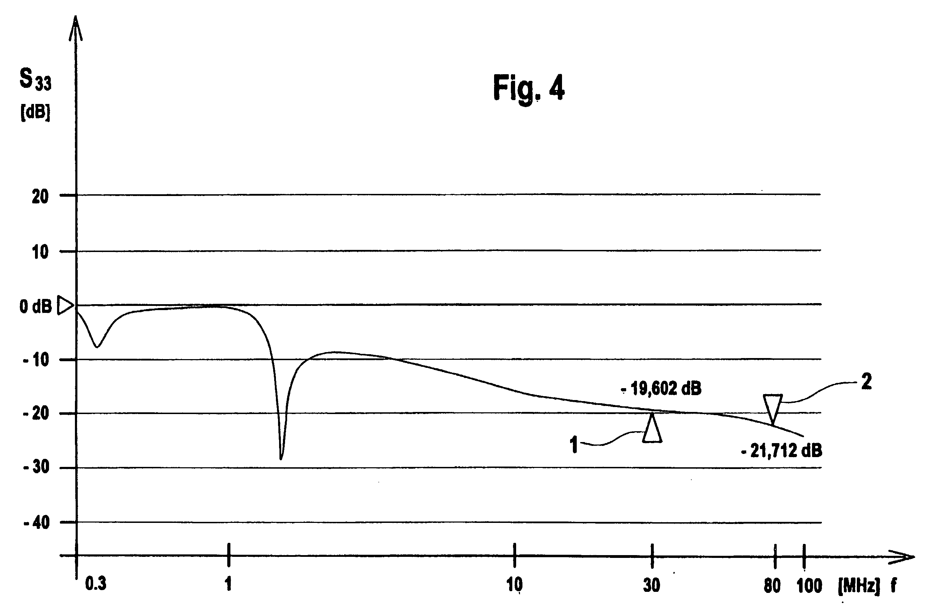

Ähnliches gilt gemäß den Fig. 3 und 4 für die an den Toren 2 und 3 reflektierten Signalleistungen S₂₂ und S₃₃. Die Werte bei 30 MHz und 80 MHz sind im ersten Fall - 18,357 dB und -20,593 dB und im zweiten Falle -19,602 dB bzw. - 21,712 dB.

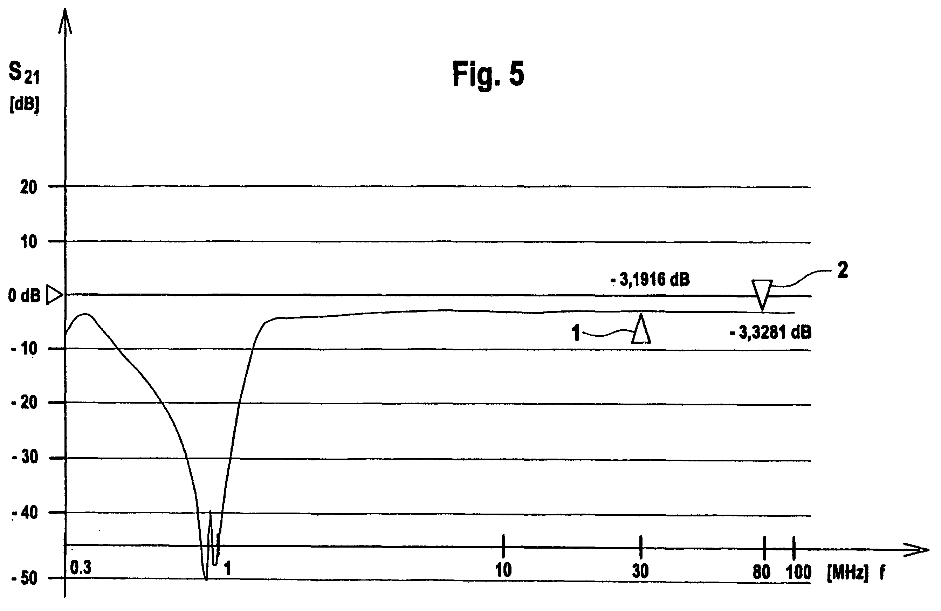

Fig. 5 zeigt den zwischen Tor 1 und Tor 2 übertragenen Verlauf der Signalleistung, und den Werten bei 30 MHz von -3,1916 dB und bei 80 MHz von -3,3281 dB kann man entnehmen, daß hier eine sehr gleichmäßige Übertragung über den Frequenzbereich stattfindet.

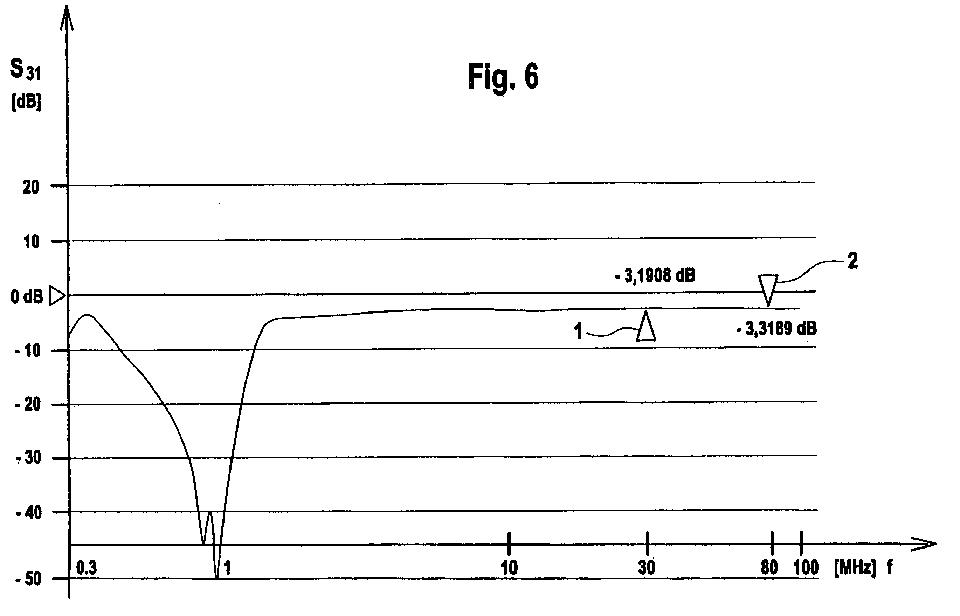

Fig. 6 zeigt in zu Fig. 5 analogerweise die Übertragung der Signalleistung S₃₁ zwischen Tor 1 und Tor 3. Auch hier erkennt man aus dem Wert von -3,1908 dB bei 30 MHz und -3,3189 dB bei 80 MHz nicht nur den gleichmäßigen Verlauf in diesem Frequenzbereich, sondern auch im Vergleich mit den Werten von Fig. 5 die gleichmäßige Aufteilung der Signalleistung auf die beiden Zweige der Kombinator-Teiler-Einheit.

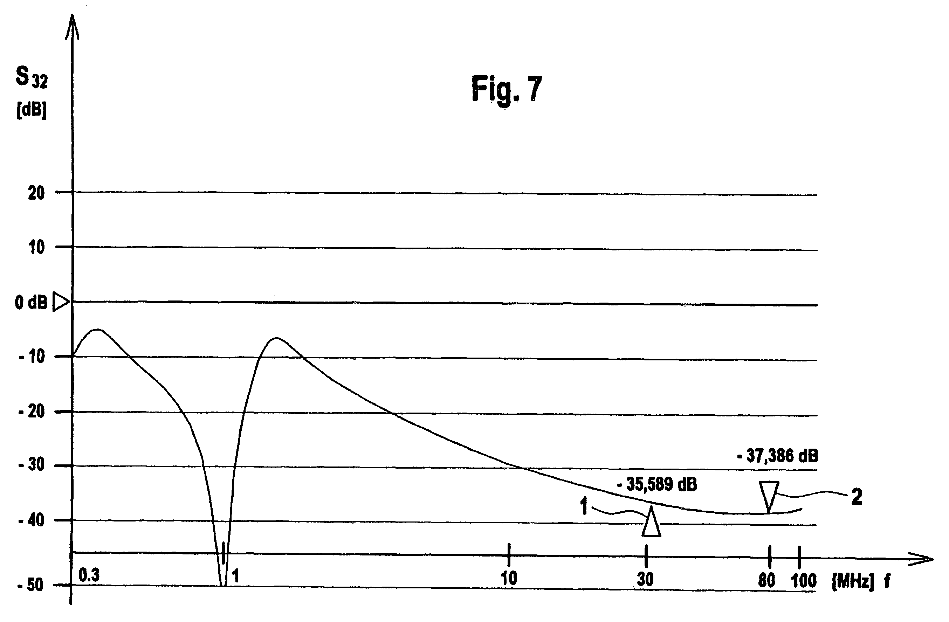

Fig. 7 zeigt den Verlauf der zwischen Tor 2 und Tor 3 übertragenen Signalleistung S_{32,} die wie die Werte von -35,589 dB bei 30 MHz und - 37,386 dB bei 80 MHz zeigen, sehr gering ist. Damit wird die Forderung nach der Entkopplung der Tore 2 und 3 sichergestellt. Die jeweils im Bereich von 1 MHz auftretende tiefe Einsenkung ist auf den Einfluß der Bypasszweige zurückzuführen und liegt außerhalb des für die Übertragung interessierenden Frequenzbereichs.

Als Ergebnis der durchgeführten Messungen ergab sich, daß die an die beschriebene Kombinator-Teiler-Einheit gestellten Forderungen bezüglich einer prioritätenfreien parallelen Mehrfachnutzung einer Antenne, der Übertragung des gewünschten Frequenzbereiches, der Übertragung der erforderlichen Hochfrequenzleistung, der Entkopplung der Antenneneingänge der Funkgeräte, der Gleichspannungs-Kopplung der Antenne mit den Funkgeräten, sowie der Gleichspannung-Entkopplung der beiden Funkgeräte ohne Einschränkung erfüllt werden.

## Patentansprüche

1. Elektrische Kombinator-Teiler-Einheit, die einen Transformator (TX1) aufweist, dessen Primärwicklung an einem Ende mit einem Master-Tor (Tor 1) und am anderen Ende mit Null-Potential verbunden ist, während die Sekundärwicklung an beiden Enden über einen Kondensator (C2, C3) jeweils mit einem Slave-Tor (Tor 2, Tor 3) und am Mittelabgriff (TX2) mit Null-Potential verbunden ist, **dadurch gekennzeichnet, dass** zur Reduktion der Antennenanzahl an einem Kampffahrzeug, in dem mehrere Kommunikationsendgeräte angeordnet sind, jeweils zwei Kommunikationsendgeräte an eine gemeinsame Antenne gekoppelt sind, indem die Antenne an das zur gleichstrommäßigen Entkoppelung über einen Kondensator (C1) mit der Primärwicklung des Transformators (TX1) verbundene Master-Tor (Tor 1) angeschlossen ist, während an jedes der Slave-Tore (Tor 2, Tor 3) eines der Kommunikationsendgeräte angeschlossen ist und das Master-Tor mit den Slave-Toren jeweils über einen nur Gleichstrom übertragenden Bypasszweig (L1-D2, L2-D1) zur Zuführung einer Antennenspannung verbunden ist.

2. Kombinator-Teiler-Einheit nach Anspruch 1, **dadurch gekennzeichnet, dass** jeder Bypasszweig eine Drossel (L1, L2) und eine in Richtung auf das Master-Tor (Tor 1) gepolte Diode (D2, D1) aufweist, der ein Kondensator (C5, C4) parallel geschaltet ist.

## Claims

1. Electric combiner-divider unit, comprising a transformer (TX1) whose primary winding is connected at one end to a master gate (gate 1) and at the other end to zero potential, while the secondary winding is connected at both ends respectively, via a capacitor (C2, C3), to a slave gate (gate 2, gate 3) and is connected at the centre tap (TX2) to zero potential, **characterized in that**, for the purpose of reducing the number of antennae on a combat vehicle in which several communications terminals are disposed, two communications terminals are in each case coupled to a common antenna, **in that** the antenna is terminated to the master gate (gate 1) which, for the purpose of direct-current decoupling, is connected via a capacitor (C1) to the primary winding of the transformer (TX1), while one of the communications terminals is terminated to each of the slave gates (gate 2, gate 3), and the master gate is connected to the slave gates, in each case via a bypass branch (L1-D2, L2-D1) transmitting only direct current, for the purpose of applying an antenna voltage.

2. Combiner-divider unit according to Claim 1, **characterized in that** each bypass branch comprises a choke (L1, L2) and a diode (D2, D1), which is polarized towards the master gate (gate 1) and connected in parallel with which there is a capacitor (C5, C4).

## Revendications

1. Unité électrique de combinaison et de partage, qui comprend un transformateur (TX1) dont l'enroulement primaire est relié, à une extrémité, avec une porte maître (porte 1), et à l'autre extrémité, avec un potentiel nul, tandis que l'enroulement secondaire est relié, aux deux extrémités, par l'intermédiaire d'un condensateur (C2, C3), respectivement avec une porte esclave (porte 2, porte 3), et au niveau du piquage central (TX2), avec un potentiel nul,
**caractérisée en ce que** pour réduire le nombre d'antennes sur un véhicule de combat dans lequel sont placés plusieurs appareils terminaux de communication, respectivement deux appareils terminaux de communication sont couplés à une antenne commune, de la manière suivante, à savoir que l'antenne est raccordée à la porte maître (porte 1) couplée à l'enroulement primaire du transformateur (TX1) par l'intermédiaire d'un condensateur (C1) pour le découplage sur le plan du courant continu, tandis qu'à chacune des portes esclaves (porte 2, porte 3) est raccordé l'un des terminaux de communication, et la porte maître étant reliée aux portes esclaves respectivement par l'intermédiaire d'une branche en dérivation (L1-D2, L2-D1) ne transmettant que du courant continu, pour l'amenée d'une tension d'antenne.

2. Unité électrique de combinaison et de partage selon la revendication 1, **caractérisée en ce que** chaque branche en dérivation comprend une bobine d'arrêt (L1, L2) et une diode (D2, D1) polarisée en direction de la porte maître (porte 1) et avec laquelle est monté en parallèle, un condensateur (C5, C4).
